# EUROPEAN PATENT APPLICATION

(11) **EP 1 524 704 A2**
(43) Date of publication of application: **20.04.2005**
(21) Application number: 04255432.9
(22) Date of filing: 08.09.2004
(51) Int. Cl.: H01L 33/00, H01L 25/075

(54) **Light emission device and manufacturing method thereof**

(30) Priority: 16.09.2003 JP 2003323054
(71) Applicant: FUJI PHOTO FILM CO., LTD., Kanagawa 250-01 (JP)
(72) Inventor: Mizuyoshi, Akira, c/o Fuji Photo Film Co. Ltd., Asaka-shi, Saitama (JP)
(74) Representative: Stevens, Jason Paul

(57) **Abstract**

A light emission device (10) is constituted of LED chips (13), a driver circuit (12), and a wiring pattern (14) for connecting the individual LED chips to the driver circuit. The wiring pattern is formed by weaving line members (16x, 16y) into a cross grid, the line member being formed by coating an electro conductive core (18) with an isolating material (19). The lateral line members (16x) are connected to a negative electrode of the driver circuit, while the longitudinal line members (16y) are connected to a positive electrode of the driver circuit. Connectors (23x, 23y) are formed at cross points between the line members Negative poles of the LED chips 13 are connected to the connectors (23x) that are formed on the lateral line members (16x), while positive poles of the LED chips 13 are connected to the connectors (23y) that are formed on the longitudinal line members (16y). The wiring pattern 14 is affixed to a heat sink (22) through an adhesive agent (21).

## Description

### FIELD OF THE INVENTION

The present invention relates to a light emission device having a number of light emitting elements arranged in a pattern, and also to a manufacturing method of the light emission device.

### BACKGROUND ARTS

There have been known light emission devices having a number of light emitting elements, such as light emission diodes, arranged in a matrix, for example, in Japanese Laid-open Patent Applications Nos. Hei 7-287535 and 6-301342. These light emission devices are used as illuminations, optical fixing devices, or display panels. For use as a display panel, the light emitting elements are individually controlled on and off. The light emitting elements are mounted on an implemental surface of a substrate, where a circuit pattern is formed to connect the light emitting elements electrically to a driver circuit.

As well-known in the art, the circuit pattern is formed on the substrate, which has a number of electro conductive layers and isolating layers laminated on one another, by use of photo lithography or etching. As materials of the substrate, glass epoxy and the like are generally used. But because glass epoxy is inferior in heat radiation properties, where the light emitting elements are to be mounted highly densely, a metallic material, such as aluminum or metal core, or ceramics are used as the substrate material.

However, in comparison with the general cases where the circuit pattern is formed on a grass epoxy substrate, a higher processing cost is needed for forming the circuit pattern on the metallic material or ceramics as having high heat radiation properties. The high processing cost has been hindering the attempt to save the total production costs of the articles.

### SUMMARY OF THE INVENTION

In view of the foregoing, a primary object of the present invention is to provide a light emission device that can be manufactured at a low cost while achieving good heat radiation properties. Another object of the present invention is to provide a manufacturing method of such a light emission device.

To achieve the above and other objects, a light emission device of the present invention comprises a plural number of light emitting elements, a driver circuit for driving the light emitting elements, and a wiring pattern for connecting the driver circuit electrically to the light emitting elements, wherein the light emission device comprises a plural number of line members constituting the wiring pattern, each of the line members being formed by coating an electro conductive core with an isolating material; and connectors formed by cutting away the isolating material partially from each of the line members so as to expose the core partly, the connectors being connected to respective poles of the light emitting elements.

According to a preferred embodiment, the wiring pattern is formed by weaving the line members into a cross grid, and the connectors are provided at cross points between longitudinal and lateral line members.

According to another preferred embodiment, the wiring pattern is constituted of at least a twist pair cable that is formed by interlacing a pair of line members with each other. The line members of each pair are connected to a positive electrode and a negative electrode of the driver circuit respectively.

In a method of manufacturing a light emission device having a plural number of light emitting elements connected to a driver circuit through a wiring pattern, the present invention comprises steps of constituting the wiring pattern of a plural number of line members, each of the line members being formed by coating an electro conductive core with an isolating material; forming connectors by cutting away the isolating material partially from each of the line members so as to expose the core partly; and connecting opposite poles of each of the light emitting elements to the connectors.

The wiring pattern is preferably formed by weaving the line members into a cross grid. Then the connectors may be formed at cross points between the line members simultaneously by planing off one side surface of the wiring pattern.

It is also preferable to constitute the wiring pattern by use of at least a twist pair cable that is formed by interlacing a pair of line members with each other, which are connected to a positive electrode and a negative electrode of the driver circuit respectively.

According to the present invention, the wiring pattern for connecting the light emitting elements to the driver circuit is constituted of a plural number of line members that are each formed by coating an electro conductive core with an isolating material, and the connectors are formed by cutting away the isolating material partially from each of the line members so as to expose the core, and the connectors are connected to respective poles of the light emitting elements.

This configuration ensures superior heat radiation properties without the need for any expensive fine-processing techniques, like photo lithography or etching. Therefore, the present invention will save the manufacturing cost of the light emission device.

### BRIEF DESCRIPTION OF THE DRAWINGS

The above and other objects and advantages will become more apparent from the following description of the preferred embodiments when read in connection with the appended drawings, wherein like reference numerals designate equivalent elements throughout the whole figures, and wherein:
Figures 1A and 1B are respectively a top plan view and a partly sectional side view of a light emission device according to an embodiment of the present invention;
Figure 2A is a flow chart illustrating manufacturing procedures of the light emission device; Figures 2B, 2C, 2D and 2E are top plan views illustrating the light emission device in respective stages of manufacture in correspondence with the flow chart;
Figure 3 is a side view, partly in section, illustrating a light emission device according to a second embodiment of the present invention, wherein ends of line members are bent down;
Figure 4 is an explanatory sectional view of a light emission device according to a third embodiment of the present invention, having a recessed mounting surface for each LED;
Figure 5 is an explanatory top plan view of a light emission device according to a fourth embodiment of the present invention, wherein a wiring pattern is constituted of twist pair cables;
Figures 6A and 6B are respectively top plan view and a side view of an LED chip having opposite poles on one side; and
Figure 7 is an explanatory diagram illustrating an embodiment where the LED chips as shown in Fig.6 are mounted on a twist pair cable.

### DESCRIPTION OF THE PREFERRED EMBODIMENTS

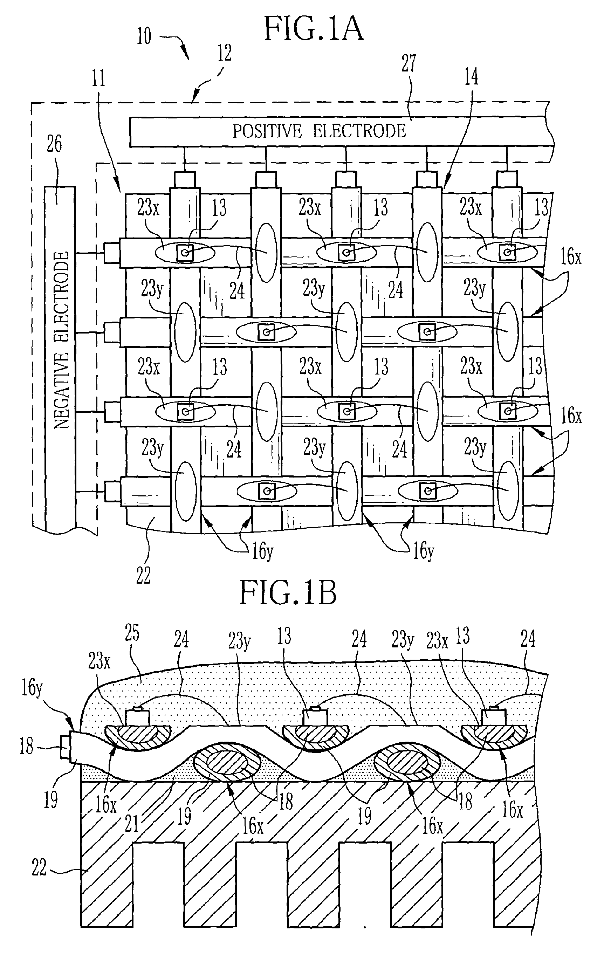

As shown in Fig. 1A, a light emission device 10 consists of a main body 11 and a driver circuit 12. The main body 11 has a large number of LED (light emitting diode) chips 13 as light emitting elements, and a wiring pattern 14 that connects the respective LED chips 13 to the driver circuit 12. The LED chips 13 are arranged in a matrix, and are mounted on the wiring pattern 14. The driver circuit 12 applies a voltage on the LED chips 13 to turn them on.

The wiring pattern 14 is produced by weaving a number of lateral line members 16x and a number of longitudinal line members 16y into a cross grid, as shown in Figs. 1A and 1B. The lateral direction and the longitudinal direction of the wiring pattern 14 may be called X-direction and Y-direction respectively. Each line member 16x or 16y is made by coating an electro conductive core 18 with an isolating material 19. The lateral line members 16x are isolated from the longitudinal line members 16y, and provide minus or negative wiring, while the longitudinal line members 16y provide plus or positive wiring.

As a material of the core 18, a metal material, including aluminum, aluminum alloy, copper, copper alloy, is usable. As the isolating material 19, polyurethane, polyethylene, vinyl chloride, polyester, polyimide, polyamide, polyamide-imide, polyamide-imide-urethane, nylon, vanish for exclusive use as enamel, or a compound of some of these materials is usable. In order to make the line members 16x and 16y bond to each other at their cross points, the isolating material 19 preferably contains a self-fusion material that is softened and bonds as being pressured. As materials having such properties, there are butyral resin, epoxies and esters, and more concretely polyamide and butyl rubber.

The wiring pattern 14 is secured by being affixed on its bottom side to a heat sink 22 through an adhesive agent 21. To improve the heat radiation efficiency of the wiring pattern 14, it is preferable to bring some portions of the bottom side of the wiring pattern 14 in direct contact with the heat sink 22 on affixing the wiring pattern 14 to the heat sink 22. As an example of the adhesive agent 21, an epoxy resin with good heat conductance is used. Connectors 23x and 23y are provided on a top side of the wiring pattern 14, particularly at the cross points between the line members 16x and 16y. The connectors 23x and 23y are connected to the respective poles of the LED chips 13. These connectors 23x and 23y are each formed by cutting out a portion of the line member 16x or 16y so as to expose the core 18 partly.

Each of the LED chips 13 has a positive pole on its top, and a negative pole on its bottom. The LED chips 13 are affixed by cementing their bottom sides to the connectors 23x and thus connecting the negative poles to the connectors 23x that are formed on the lateral line members 16x. The positive poles of the LED chips 13 are connected through bonding wires 24 to the connectors 23y that are formed on the longitudinal line members 16y. Mounting density, i.e. the number per unit area, of the LED chips 13 depends upon the spacing between the line members 16x and 16y, which can be defined appropriately by changing the boldness of the individual line members 16x and 16y, or the number of line members per unit area.

As shown in Fig. 1B, each of the connectors 23x and 23y has a flat surface, so as to facilitate mounting the LED chip 13 thereon or bonding the wire 24 thereto. Since the cross points between the line members 16x and 16y rise over other portions of the wiring pattern 14, the connectors 23x and 23y may be formed altogether by planing off the top side of the wiring pattern 14 to an extent that the isolating materials 19 and upper fragments of the core 18 are cut out at the cross points.

As a raw material for the heat sink 22, a metal with good heat conductance, like aluminum or copper, is used. The top side of the wiring pattern 14 is coated with a transparent resin 25 of high light permeability, such as a clear epoxy resin or a silicone resin. Thereby, the LED chips 13 and the wires 24 are protected.

The driver circuit 12 is provided with a negative electrode 26 and a positive electrode 27, wherein the negative electrode 26 is corrected to the lateral line members 16x, and the positive electrode 27 is connected to the longitudinal line members 16y. The driver circuit 12 can control the LED chips 13 each individually on and off. For example, the driver circuit 12 can turn only the left and uppermost one of the LED chips 13 on by applying the voltage to the leftmost one of the longitudinal line members 16y and the uppermost one of the lateral line members 16x. As being able to control the LED chips 13 each individually, the light emission device 10 may be used as a display, or may control light intensity when applied to an illumination device or an optical fixing device.

Needless to say, it is not always necessary to control the light emitting elements each individually if the light emission device is used as an illumination device or an optical fixing device. In that case, it is possible to use either one of the electrodes of the driver circuit as a common electrode to a plural number of line members, so that the light emitting elements may be controlled line by line. In a case where it is not necessary to control even the light intensity, it is not necessary to control on-off of the light emitting elements at all.

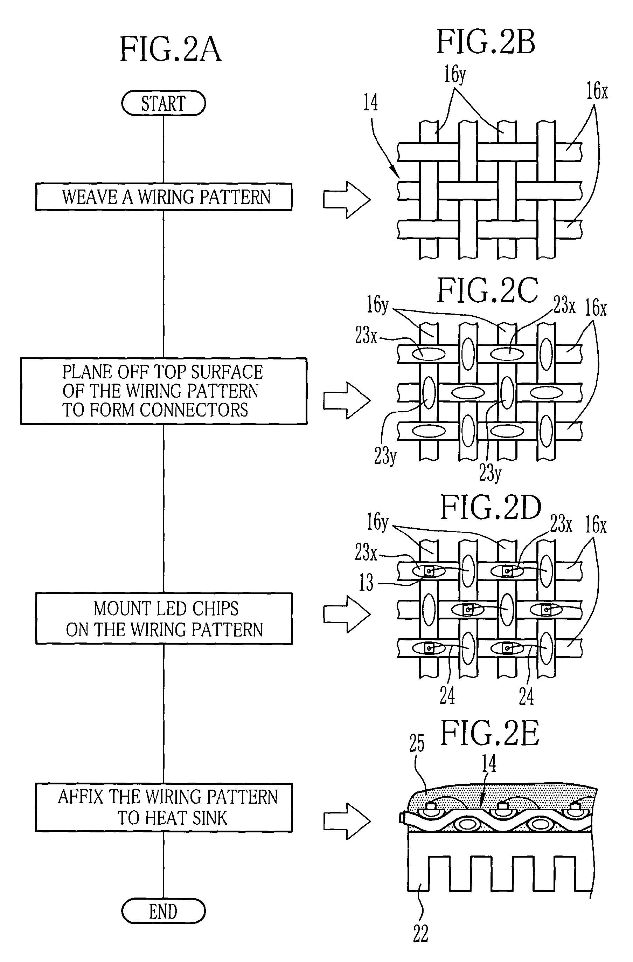

Now the manufacturing method of the light emission device 10 will be described with reference to Figs. 2A to 2E.

First, the line members 16x and 16y are woven into a cross grid to form the wiring pattern 14, as shown in Fig. 2B. Next, the top side of the wiring pattern 14 is planed off by grinding uppermost portions of the cross points between the line members 16x and 16y, to form the connectors 23x and 23y altogether, as shown in Fig.2C. After affixing the negative poles or bottom sides of the LED chips 13 to the connectors 23x, the positive poles of the LED chips 13 are connected to the connectors 23y through the bonding wires 24, as shown in Fig. 2D. After having the LED chips 13 mounted thereon, the wiring pattern 14 is affixed on the bottom side to the heat sink 22, and the top side of the wiring pattern 14 is coated with the transparent resin 25, as shown in Fig.2E, thereby completing the main body 11. Terminals of the line members 16x and 16y are respectively connected to the negative electrode 26 and the positive electrode 27 of the driver circuit 12, completing the light emission device 10.

This way, the light emission device 10 is manufactured without the need for expensive fine-processing, such as photo lithography or etching.

In addition, because the wiring pattern 14 is directly affixed to the heat sink 22 without the use of any epoxy printed circuit board that is inferior in heat conductance, the light emission device 10 achieves high heat radiation properties.

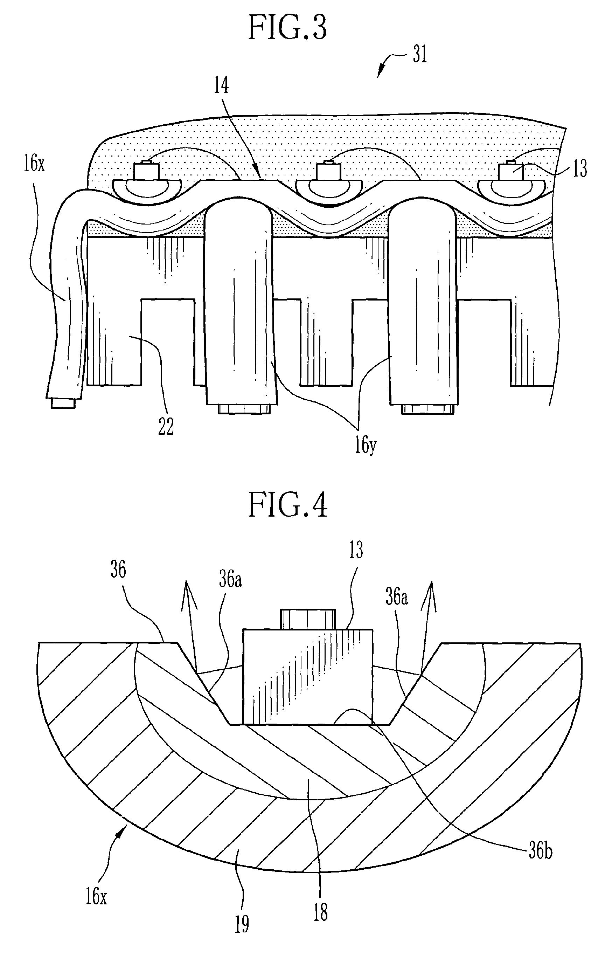

In the above embodiment, the terminals of the line members 16x and 16y extend sideways from the main body 11. But it is possible to bend the terminals of the line member 16x and 16y downward of the main body 31 as shown in Fig.3. According to this embodiment, a driver circuit may be disposed under the main body 31, so that horizontal lengths of the light emission device may be reduced.

It is also possible to form each individual connector for the LED chip 13 as a recess, as shown in Fig.4. The LED chip 13 is mounted on a bottom 36b of the recess 36. Then, reflection surfaces 36a are provided around the LED chip 13. Because light beams emitted from side surfaces of the LED chips 13 are reflected upward by the reflection surfaces 36a, the efficiency of light emission is improved.

With regard to the reflection efficiency, it is preferable to use aluminum as the material of the core 18. But concerning the heat conductance, copper is more preferable. To take advantages of both of these materials, it is possible to make the core 18 of copper, and plate the obverse surface of the connector 36 with aluminum. It is of course possible to use other materials than aluminum to form a reflective surface on the connector 36, insofar as the material is appropriate in view of wavelengths of the light beams from the LED chips 13. As an alternative, aluminum is used as the material of the core 18 of the individual lateral line member 16x on which the connector 23x for the LED chip 13 is formed, while copper is used as the material of the core 18 of the individual longitudinal line member 16y. That is, the cores 18 of the line members 16x and 16y may be made of different materials from each other.

It is also possible to use heat pipes as the material of the core 18, because the heat conductance of the heat pipe is very high. It is also possible to weave the heat pipes into the wiring pattern after it is constituted of the line members. Because the heat pipes work as heat radiators, the heat sink can be unnecessary for the wiring pattern interlaced with the heat pipes in a case where the heat energy generated from the wiring pattern is small. In that case, the light emission device can be still more minimized. To enhance the strength of the wiring pattern, it is possible to weave non-conductive glass fibers into the wiring patter.

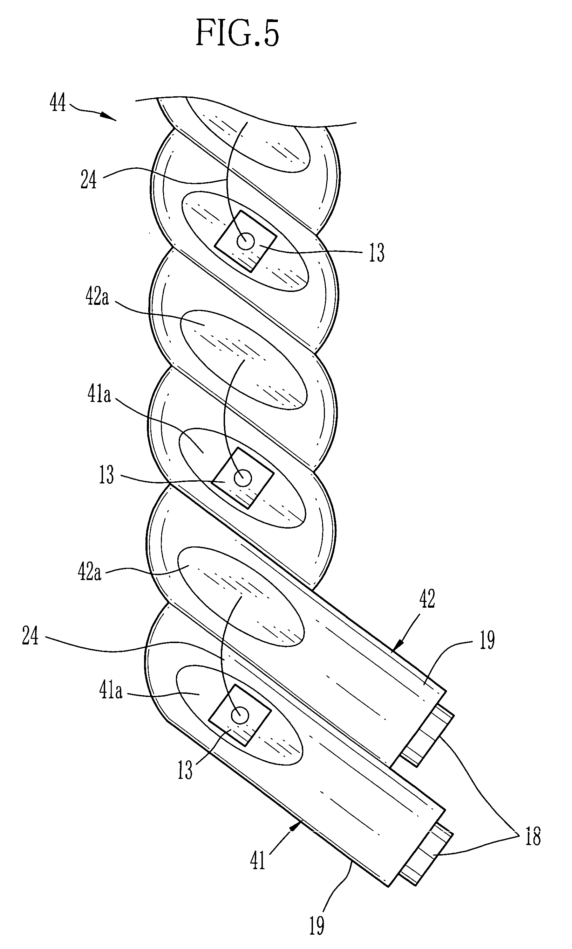

In the above embodiment, the wiring pattern 14 is formed by weaving the line members 16x and 16y into a cross grid. But the present invention is not to be limited to this embodiment. As shown in Fig. 5, a twist pair cable 44 may be used as a wiring pattern. The twist pair cable 44 is formed by interlacing a negative line member 41 and a positive line member 42. Like the wiring pattern 14, uppermost fragments of the line members 41 and 42 are cut away to form negative connectors 41a and positive connectors 42a respectively. The negative pole of the individual LED chip 13 is mounted on the negative connector 41a, while the positive pole of the individual LED chip 13 is connected to the positive connector 42a through a bonding wire 24. The single twist pair cable 44 may constitute a wiring pattern, or a plural number of such twist pair cables 44 may constitute a wiring pattern.

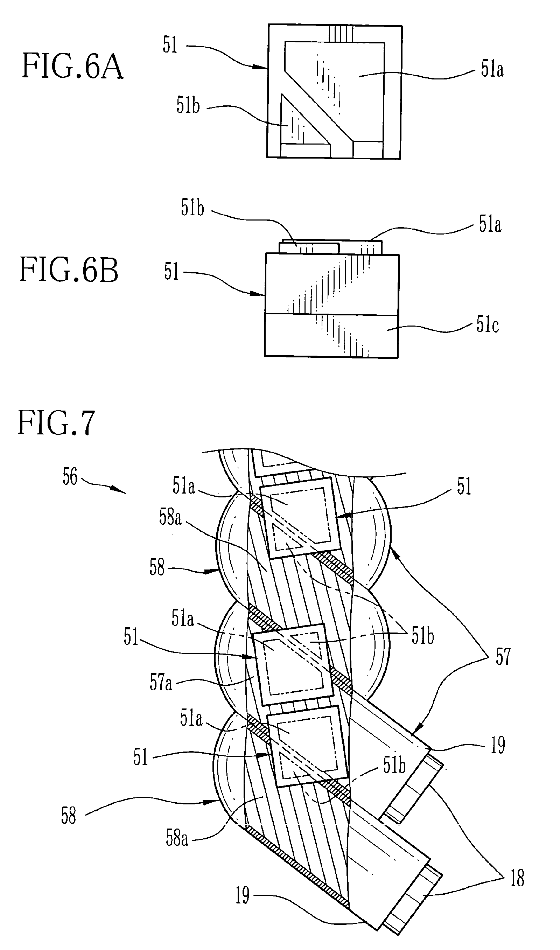

Although the above embodiments use such LED chips that have positive and negative poles on their top and bottom sides respectively, it is possible to use LED chips that have positive and negative poles 51a and 51b on their top side, as shown in Fig.6.

An example of a chip substrate 51c is a sapphire substrate, on which gallium nitride semiconductor layers of different kinds are formed atop another. Because the sapphire substrate is superior in forming layers from gallium materials, it is widely used in blue LEDs that emit ultraviolet or blue light beams. It is possible to use LED chips that do not use the sapphire substrates. Instead, the substrate of the LED chip may be made of gallium phosphide, gallium arsenide, indium phosphide, silicon carbide, or gallium nitride, or a compound of any of these materials.

As shown in Fig.7, the LED chips 51 are mounted on a twist pair cable 56 with their top side down, that is, in the face down bonding style.

Like in the above twist pair cable 44, connectors 57a and 58a of the twist pair cable 57 are formed on positive and negative line members 57 and 58 by partially cutting away their isolating materials 19 and upper fragments of their cores 18. But in the twist pair cable 56, the connectors 57a and 58a are formed adjacent to each other by cutting away the line members 57 and 58 deeper than the line members 41 and 42 of the twist pair cable 44.

It is to be noted that hatched areas in Fig. 7 show the cutaway portions of the line members 57 and 58, and more particularly, roughly hatched areas show the exposed portion of their cores 18, whereas finely hatched areas show the cut edges of their isolating materials 19. Each of the LED chips 51 is mounted across the adjacent two of the connectors 57a and 58a in the face down bonding style, such that the positive pole 51a is in contact with the connector 57a of the positive line member 57, and the negative pole 51b is in contact with the connector 58a of the negative line member 58. This face down bonding style configuration has advantages that it does not need any boding wires, and the heat radiation properties are improved.

Although the LED chips 51 are mounted on the twist pair cable type wiring pattern in the above embodiment, it is possible to mount the LED chips 51 in the face down bonding style on a cross grid type wiring pattern like as shown in Fig.1, if only the positive connectors are formed close to the negative connecters in one-to-one relationship. Besides blue LED chips, many kinds of green LED chips have opposite poles on one side, like the LED chip 51. Therefore, combining the above described wiring pattern with red, green and blue LED chips makes it possible to manufacture a full-color display device at a very low cost.

Although the above described embodiments use LED chips as the light emitting elements, the light emitting element is not to be limited to LED, but may be an electroluminescence element, a laser diode having a planer light emitting surface, or the like.

## Claims

1. A light emission device (10) comprising a plural number of light emitting elements (13, 51), a driver circuit (12) for driving said light emitting elements, and a wiring pattern (14, 44, 56) for connecting said driver circuit electrically to said light emitting elements, said light emission device comprising:
a plural number of line members (16x,16y; 41,42; 57,58) constituting said wiring pattern, each of said line members being formed by coating an electro conductive core (18) with an isolating material (19); and
connectors (23x,22y; 41a,42a; 57a,58a) formed by cutting away said isolating material partially from each of said line members so as to expose said core partly, said connectors being connected to respective poles (51a, 51b) of said light emitting elements.

2. A light emission device as claimed in claim 1, wherein said wiring pattern is formed by weaving said line members into a cross grid (14), and said connectors (23x,23y) are provided at cross points between longitudinal and lateral line members.

3. A light emission device as claimed in claim 2, wherein said longitudinal line members (16y) are connected to an electrode (27) of said driver circuit, and said lateral line members (16x) are connected to an opposite electrode (26) of said driver circuit, and wherein each of said light emitting elements is connected at its one pole to one of said connectors that are formed on said longitudinal line members, and at its opposite pole to one of said connectors that are formed on said lateral line members.

4. A light emission device as claimed in claim 1, wherein said wiring pattern comprises at least a twist pair cable (44, 56) that is formed by interlacing a pair of line members (41, 42; 57,58) with each other, which are connected to a positive electrode and a negative electrode of said driver circuit respectively.

5. A light emission device as claimed in claim 3 or 4, wherein each of said light emitting elements (13) has its opposite poles on its top and bottom sides respectively, and wherein said bottom side is connected directly to one of said connectors having one polarity, whereas the pole on said top side is connected through a bonding wire (24) to one of said connectors having an opposite polarity.

6. A light emission device as claimed in claim 5, wherein said connectors, which said bottom sides of said light emitting elements are directly connected to, are shaped into recessed surfaces (36), which serve as reflection surfaces for reflecting light beams emitted sideways from said light emitting elements.

7. A light emission device as claimed in claim 1, wherein each of said light emitting elements (51) has its opposite poles (51a, 51b) on its top side, and said opposite poles are connected directly to adjacent two of said connectors (57a, 58a) in a face down bonding style, said adjacent two connectors having opposite polarities.

8. A light emission device as claimed in claim 1, wherein said connectors are formed on one side of said wiring pattern, and a heat sink (22) is affixed to an opposite side of said wiring pattern.

9. A method of manufacturing a light emission device having a plural number of light emitting elements connected to a driver circuit through a wiring pattern, said method comprising steps of:
constituting said wiring pattern (14, 44, 56) of a plural number of line members (16x,16y; 41,42; 57,58), each of said line members being formed by coating an electro conductive core (18) with an isolating material (19);
forming connectors (23x,22y; 41a,42a; 57a,58a) by cutting away said isolating material partially from each of said line members so as to expose said core partly; and
connecting opposite poles of each of said light emitting elements to said connectors.

10. A method of manufacturing a light emission device as claimed in claim 9, wherein said wiring pattern (14) is formed by weaving said line members (16x,16y) into a cross grid.

11. A method of manufacturing a light emission device as claimed in claim 10, wherein said connectors (23x,23y) are formed at cross points between said line members simultaneously by planing off one side surface of said wiring pattern.

12. A method of manufacturing a light emission device as claimed in claim 9, wherein said wiring pattern is constituted of at least a twist pair cable (44, 56) that is formed by interlacing a pair of line members (41,42; 57,58) with each other, which are connected to a positive electrode and a negative electrode of said driver circuit respectively.

13. A method of manufacturing a light emission device as claimed in claim 12, wherein said connectors (41a, 42a; 57a, 58a) are formed on said line members at adjacent positions to each other, simultaneously by planing off one side of said twist pair cable.

14. A method of manufacturing a light emission device as claimed in claim 11 or 13, further comprising a step of affixing a heat sink (22) to an opposite side of said wiring pattern from said connectors.
